# EUROPEAN PATENT APPLICATION

(11) **EP 4 328 984 A1**
(43) Date of publication of application: **28.02.2024**
(21) Application number: 22885890.8
(22) Date of filing: 25.10.2022
(51) Int. Cl.: H01L 31/18

(54) **EMITTER, SELECTIVE EMITTER CELL PREPARATION METHOD AND SELECTIVE EMITTER CELL**

(30) Priority: 25.10.2021 CN 202111238759
(71) Applicant: Trina Solar Co., Ltd, Changzhou, Jiangsu 213031 (CN)
(72) Inventor: LIU, Chengfa, hangzhou, Jiangsu 213031 (CN); CHEN, Yiqi, hangzhou, Jiangsu 213031 (CN); ZOU, Yang, hangzhou, Jiangsu 213031 (CN); LIU, Zhiyuan, hangzhou, Jiangsu 213031 (CN); WANG, Yao, hangzhou, Jiangsu 213031 (CN); CHEN, Daming, hangzhou, Jiangsu 213031 (CN); ZHANG, Xueling, hangzhou, Jiangsu 213031 (CN); CHEN, Yifeng, hangzhou, Jiangsu 213031 (CN); FENG, Zhiqiang, hangzhou, Jiangsu 213031 (CN)
(74) Representative: Arnold & Siedsma
(86) International application number: PCT/CN2022/127190
(87) International publication number: WO 2023/072013

(57) **Abstract**

The present application provides an emitter, a selective emitter cell preparation method and a selective emitter cell. The preparation method for the selective emitter cell comprises: sequentially irradiating a boron-rich layer using lasers of at least two different wavelengths, and sequentially doping boron atoms in the boron-rich layer to the same region of a silicon wafer by means of a laser, to obtain the emitter.

## Description

This application claims priority to the Chinese patent application No. 202111238759.X filed with the China National Intellectual Property Administration on October 25, 2021, the content of which is hereby incorporated by reference in its entirety.

### TECHNICAL FIELD

The present disclosure belongs to the technical field of solar cells, and relates, for example, to a method for preparing an emitter, and a method for preparing a selective emitter cell, as well as a selective emitter cell.

### BACKGROUND

A selective emitter in a solar cell is a structure in which the region where the metal grid line is in contact with a silicon wafer is heavily doped, and the non-metal contact region in the silicon wafer is lightly doped. Such a structure can reduce the contact resistance of the metal contact region and reduce the serial resistance of the cells. Besides, the lightly doped region can effectively reduce recombination of carriers and improve surface passivation. Therefore, the preparation of the selective emitter structure will improve the fill factor of the cells and the short-wave response of the cells, and ultimately improve the efficiency of the cells.

N-type TOPCon cells are considered to be a next generation product upgraded from the passivated emitter and rear cells (PERC), which can improve efficiency of solar cells. The front boron diffused selective emitter structure is a necessary process for TOPCon cells to improve cell efficiency. However, there is no low-cost mature process in the related technology that can be applied for mass production. In related technologies, two-step diffusion, reverse etching, predeposition of patterned boron source, etc. are usually used to prepare selective emitters in TOPCon cells, with low economy. Moreover, the laser doping process in related technologies is difficult to dope silicon with boron atoms in the borosilicate glass, and the difference in solid solubility of boron atoms in silicon oxide and silicon causes the surface concentration to drop significantly after a laser treatment, which can increase the junction depth but cannot create a good ohmic contact.

CN109742172A discloses a method for preparing a N-type selective emitter bifacial cell by spin-coating boron source and laser doping. The preparation method includes: texturing a N-type silicon wafer; spin-coating a front side with an organic boron source and drying; performing diffusion in a diffusion furnace to form a front lightly doped emitter; laser dopingthe borosilicate glass (BSG) in the front side to form a heavily doped selective emitter; cleaning a back side to remove silica glass (PSG); phosphorus diffusing in the back side to form a phosphorus back field; depositing anti-reflective passivation films on the front and back sides; and printing metal electrodes on the front and back sides to complete the cell production.

CN112670353A discloses a boron-doped selective emitter cell and a preparation method thereof. The selective emitter cell includes N-type crystalline silicon, two positive electrodes disposed on a front side of the N-type crystalline silicon, and two negative electrodes disposed on a back side of the N-type crystalline silicon. A SiO₂ layer is disposed on the back side of the N-type crystalline silicon, and a phosphorus-doped polysilicon layer is disposed on the SiOz layer. Besides, it discloses preparation of a selective boron selective emitter (SE) structure using boron paste printing and laser propulsion.

CN113035976A discloses a boron-doped selective emitter and a preparation method thereof, and a boron-doped selective emitter cell. The preparation method includes: texturing a silicon wafer and then preparing a heavily doped region and a lightly doped region on a surface of the silicon wafer. First,the surface of the silicon wafer is covered with a boron dopant layer, with a boron dopant covered region not smaller than the heavily doped region; the boron dopant within the heavily doped region is laser doped to form silicon boride; then high-temperature propulsion is performed on the silicon boride to form a heavily doped region; and then a lightly doped region is formed on the surface of the silicon wafer to produce a boron-doped selective emitter.

Although the above-mentioned literatures improve the selective emitter preparation process in different aspects, the laser doping process is still difficult to dope the P+ layer with the boron source in the borosilicate glass (BSG), and the use of laser doping would change the surface concentration and junction depth of the original silicon wafer at the same time, that is, reduce of the surface concentration and increase of the junction depth.

### SUMMARY

The present disclosure provides a method for preparing an emitter, and a method for preparing a selective emitter cell, as well as a selective emitter cell. Lasers with at least two wavelengths are used to perform boron doping on the surface of a silicon wafer, which can effectively adjust the concentration and depth of boron doping on the surface of the silicon wafer.

In a first aspect, the present disclosure provides a method for preparing an emitter. The method for preparing an emitter includes: irradiating a boron-rich layer sequentially with at least two lasers with different wavelengths to sequentially dope a same region of a silicon wafer with boron atoms in the boron-rich layer, thereby obtaining the emitter.

In a second aspect, the present disclosure provides a method for preparing a selective emitter cell. The preparation method includes: texturing a silicon wafer, preparing a lightly doped emitter and a boron-rich layer, preparing a heavily doped selective emitter, and preparing metal electrodes, thereby obtaining the selective emitter cell.

The heavily doped selective emitter is prepared by the method for preparing an emitter as described in the first aspect. A first laser doping and a second laser doping are for sequentially patterned doping a same region on a surface of the lightly doped emitter with boron atoms in the boron-rich layer to obtain the heavily doped selective emitter. The heavily doped selective emitter is embedded in the lightly doped emitter.

In a third aspect, the present disclosure provides a selective emitter cell. The selective emitter cell is obtained by using the method for preparing a selective emitter cell as described in the second aspect.

### BRIEF DESCRIPTION OF ACCOMPANYING DRAWINGS

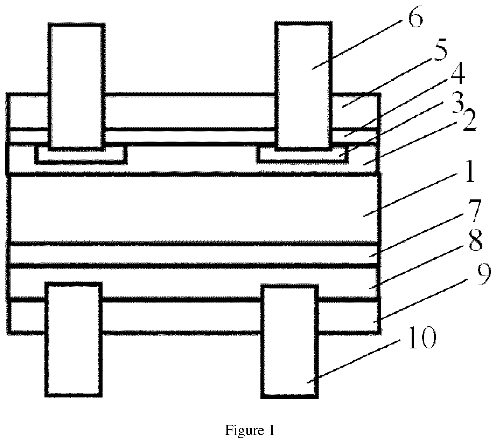

Figure 1 is a schematic structural diagram of a selective emitter cell provided in the present disclosure.

1-silicon wafer substrate; 2-lightly doped emitter; 3-heavily doped selective emitter; 4-front aluminum oxide layer; 5-front passivation film layer; 6-front metal electrode; 7- tunnel layer; 8-doped polysilicon layer; 9-back passivation film layer; 10-back metal electrode.

### DETAILED DESCRIPTION

In the description of the present disclosure, it should be understood that the terms "center", "longitudinal", "transverse", "upper", "lower", "front", " back", "left", "right", "vertical", "horizontal", "top", "bottom", "inner", "outer", etc. indicate orientations or positional relationships on the basis of the orientations or positional relationships shown in the drawings. These terms are only for the convenience of describing the present disclosure and simplifying the description, rather than indicating or implying that the referred devices or elements must have certain orientations, or be constructed or operated in certain orientations. In addition, the terms "first", "second" and the like are used for descriptive purposes only, and may not be interpreted as indicating or implying relative importance or implicitly specifying the quantity of the indicated technical features. Accordingly, the features defined as "first", "second" and the like may explicitly or implicitly include one or more of these features. In the description of the present disclosure, "plurality" means two or more than two, unless otherwise stated.

In the present disclosure, unless otherwise clearly specified, it should be noted that terms such as "disposed", "connected" and "coupled" should be interpreted in a broad sense. For example, an element can be fixedly connected, detachably connected, or integrated to the other element; can be mechanically connected, or electrically connected; and can be directly connected to the other element, or connected to the other element through an intermediate medium, or an internal communication between two elements. Those ordinary skilled in the art may understand the specific meanings of the above terms in the present disclosure according to specific circumstances.

The present disclosure will be described below with reference to the accompanying drawings and through specific embodments.

The present disclosure provides a method for preparing an emitter, and a method for preparing a selective emitter cell, as well as a selective emitter cell. Taking advantage of the characteristics that the surface of the boron-rich layer responds differently to lasers with different wavelengths and that lasers with different wavelengths cause different depths of thermal effects on silicon, the lasers with at least two wavelengths are used to perform boron doping on the surface of a silicon wafer, which can effectively adjust the concentration and depth of boron doping on the surface of the silicon wafer. Besides, in the process of preparing selective emitter cells, lasers with two or more wavelengths are used to sequentially perform patterned laser doping, which can precisely control the surface concentration and junction depth of the laser region to obtain a heavily doped selective emitter, thereby increasing the surface concentration of the heavily doped selective emitter and increasing the junction depth at the same time. In addition, the method for preparing the selective emitter cell provided in the present disclosure is simple and easy to operate, enables to reduce the production time cost, and opens up the process window, promoting the development of high-efficient solar cell preparation technology.

In a first aspect, the present disclosure provides a method for preparing an emitter. The method for preparing an emitter includes: irradiating a boron-rich layer sequentially with at least two lasers with different wavelengths to sequentially dope a same region of a silicon wafer with boron atoms in the boron-rich layer, thereby obtaining the emitter.

The method for preparing the emitter provided in the present disclosure takes advantage of the characteristics that the surface of the boron-rich layer responds differently to lasers with different wavelengths and that lasers with different wavelengths cause different depths of thermal effects on silicon, and uses the lasers with at least two wavelengths to perform boron doping on the surface of a silicon wafer, which can effectively adjust the concentration and depth of boron doping on the surface of the silicon wafer.

Preferably, the irradiating the boron-rich layer sequentially with at least two lasers with different wavelengths includes irradiating the boron-rich layer with a first laser and then irradiating the boron-rich layer with a second laser.

Preferably, a wavelength of the first laser is less than 450 nm, and may be, for example, 440 nm, 420 nm, 400 nm, 380 nm, 350 nm, 320 nm, 300 nm, 280 nm, 250 nm, 220 nm, 200 nm, 180 nm, 150 nm or 100 nm. A wavelength of the second laser is greater than 450 nm, and may be, for example, 460 nm, 500 nm, 550 nm, 600 nm, 650 nm, 700 nm, 750 nm, 800 nm, 850 nm, 900 nm, 950 nm, 1000 nm or 1200 nm. Other unlisted values within these numerical ranges are also applicable.

Preferably, the irradiating the boron-rich layer sequentially with at least two lasers with different wavelengths includes irradiating the boron-rich layer with a first laser and then irradiating the boron-rich layer with a second laser.

Preferably, a wavelength of the first laser is greater than 450 nm, and may be, for example, 460 nm, 500 nm, 550 nm, 600 nm, 650 nm, 700 nm, 750 nm, 800 nm, 850 nm, 900 nm, 950 nm, 1000 nm or 1200 nm. A wavelength of the second laser is less than 450 nm, and may be, for example, 440 nm, 420 nm, 400 nm, 380 nm, 350 nm, 320 nm, 300 nm, 280 nm, 250 nm, 220 nm, 200 nm, 180 nm, 150 nm or 100 nm. Other unlisted values within these numerical ranges are also applicable.

The present disclosure provides two options for laser doping to prepare the emitter, including: (1) using a laser with a wavelength less than 450 nm and a laser with a wavelength greater than 450 nm to sequentially dope a same region on the surface of the silicon wafer with boron atoms in the boron-rich layer; and (2) using a laser with a wavelength greater than 450 nm and a laser with a wavelength less than 450 nm to sequentially dope a same region on the surface of the silicon wafer with boron atoms in the boron-rich layer.

In a second aspect, the present disclosure provides a method for preparing a selective emitter cell. The preparation method includes: texturing a silicon wafer, preparing a lightly doped emitter and a boron-rich layer, preparing a heavily doped selective emitter, and preparing metal electrodes, thereby obtaining the selective emitter cell.

The heavily doped selective emitter is prepared by the method for preparing an emitter as described in the first aspect. A first laser doping and a second laser doping are for sequentially patterned doping a same region on a surface of the lightly doped emitter with boron atoms in the boron-rich layer to obtain the heavily doped selective emitter. The heavily doped selective emitter is embedded in the lightly doped emitter.

The present disclosure provides two options for laser doping to prepare the heavily doped selective emitter, including: (1) using a laser with a wavelength less than 450 nm and a laser with a wavelength greater than 450 nm to sequentially patterned-dope a same region on the surface of the lightly doped emitter with boron atoms in the boron-rich layer; and (2) using a laser with a wavelength greater than 450 nm and a laser with a wavelength less than 450 nm to sequentially patterned-dope a same region on the surface of the lightly doped emitter with boron atoms in the boron-rich layer.

The method for preparing the selective emitter provided in the present disclosure takes advantage of the characteristics that lasers with different wavelengths cause different depths of thermal effects on silicon, and uses lasers with two or more wavelength to sequentially patterned-dope a same region of the lightly doped emitter with boron atoms, which can precisely control the surface concentration and junction depth of this region to obtain a heavily doped selective emitter, thereby increasing the surface concentration of the heavily doped selective emitter and increasing the junction depth at the same time. This results in a selective emitter structure with high doping concentration and deep junction in the laser region and low surface concentration and shallow junction in the non-laser region.

Preferably, a surface of the silicon wafer is textured to obtain a silicon wafer substrate.

Preferably, the silicon wafer includes an N-type silicon wafer.

Preferably, the preparing the lightly doped emitter includes:
subjecting the silicon wafer substrate to a diffusion treatmentto form the lightly doped emitter on a front side of the silicon wafer substrate.

Preferably, a surface concentration of the lightly doped emitter is in a range from 1E18 cm⁻³ to 2E20 cm⁻³, and may be, for example, 1E18 cm⁻³, 2E18 cm⁻³, 5E18 cm⁻³, 8E18 cm⁻³, 1E19 cm⁻³, 2E19 cm⁻³, 5E19 cm⁻³, 8E19 cm⁻³, 1E20 cm⁻³ or 2E20 cm⁻³. Other unlisted values within this numerical range are also applicable.

It should be noted that "E" in this application represents a scientific notation. For example, "1E18" refers to 1×10¹⁸.

Preferably, a junction depth of the lightly doped emitter is in a range from 0.1 µm to 2 µm, and may be, for example, 0.1 µm, 0.2 µm, 0.3 µm, 0.4 µm, 0.5 µm, 0.6 µm, 0.7 µm, 0.8 µm, 0.9 µm, 1 µm, 1.1 µm, 1.2 µm, 1.3 µm, 1.4 µm, 1.5 µm, 1.6 µm, 1.7 µm, 1.8 µm, 1.9 µm, or 2 µm. Other unlisted values within this numerical range are also applicable.

Preferably, a sheet resistance of the lightly doped emitter is in a range from 100 S2/sq to 500 S2/sq, and may be, for example, 100 S2/sq, 120 S2/sq, 150 S2/sq, 180 S2/sq, 200 S2/sq, 220 Ω/sq, 250Ω/sq, 280 Ω/sq, 300 S2/sq, 320 S2/sq, 350 S2/sq, 380 S2/sq, 400 S2/sq, 420 S2/sq, 450 S2/sq, 480 S2/sq or 500 Ω/sq. Other unlisted values within this numerical range are also applicable.

Preferably, the surface of the lightly doped emitter is covered with the boron-rich layer.

Preferably, a thickness of the boron-rich layer is in a range from 0.01 µm to 2 µm, and may be, for example, 0.01 µm, 0.1 µm, 0.2 µm, 0.3 µm, 0.4 µm, 0.5 µm, 0.6 µm, 0.7 µm, 0.8 µm, 0.9 µm, 1 µm, 1.1µm, 1.2 µm, 1.3 µm, 1.4 µm, 1.5 µm, 1.6 µm, 1.7 µm, 1.8 µm, 1.9 µm or 2 µm. Other unlisted values within this numerical range are also applicable.

In the present disclosure, while the silicon wafer substrate is placed in a diffusion furnace for diffusion to prepare a lightly doped selective emitter, a boron source is provided in the diffusion furnace so as to cover the surface of the lightly doped selective emitter with a boron-rich layer. In addition, the boron-rich layer on the surface of the lightly doped selective emitter can also be obtained by spin coating or silk screen printing methods. In addition, the boron-rich layer can also be formed by deposition using chemical vapor deposition methods, such as atmospheric pressure chemical vapor deposition (APCVD), low pressure chemical vapor deposition (LPCVD), plasma enhanced chemical vapor deposition (PECVD), etc.

It should be noted that there are no requirements on the structures of the diffusion furnace, spin coating device and vapor deposition device in the present disclosure. Therefore, it can be understood that those skilled in the art can select different types of, or make adaptive adjustments to the structures of, diffusion furnaces, spin coating devices and vapor deposition devices according to the usage scenarios.

Preferably, a surface concentration of the heavily doped emitter is in a range from 3E18 cm⁻³ to 1E22 cm⁻³, and may be, for example, 3E18 cm⁻³, SE18 cm⁻³, 8E18 cm⁻³, 1E19 cm⁻³, 2E19 cm⁻³, SE19 cm⁻³, 8E19 cm⁻³, 1E20 cm⁻³, 5E20 cm⁻³, 8E20 cm⁻³, 1E21 cm⁻³, 2E21 cm⁻³, SE21 cm⁻³, 8E21 cm⁻³ or 1E22 cm⁻³. Other unlisted values within this numerical range are also applicable.

Preferably, a junction depth of the heavily doped emitter is in a range from 0.2 µm to 5 µm, and may be, for example, 0.2 µm, 0.5 µm, 0.8 µm,1 µm, 1.2 µm, 1.5 µm, 1.8 µm, 2 µm, 2.3 µm, 2.5 µm, 2.8 µm, 3 µm, 3.2 µm, 3.5 µm, 3.8 µm, 4 µm, 4.2 µm, 4.5 µm, 4.8 µm or 5 µm. Other unlisted values within this numerical range are also applicable.

Preferably, a sheet resistance of the heavily doped emitter is in a range from 20 S2/sq to 200 Ω/sq, and may be, for example, 20 Ω/sq, 40 S2/sq, 60 S2/sq, 80 Ω/sq, 100 S2/sq, 120 S2/sq, 140 S2 /sq, 160 S2/sq, 180 S2/sq or 200 Ω/sq. Other unlisted values within this numerical range are also applicable.

Preferably, after the heavily doped selective emitter is prepared, the back side of the silicon wafer substrate is sequentially subjected to etching, cleaning, and depositing a tunnel layer and a doped polysilicon layer; and then wet chemical cleaning, deposition of a front aluminum oxide layer, deposition of double-sided passivation film layers, and preparation of double-sided metal electrodes are sequentially performed.

At this time, the wet chemical cleaning is for removing the polysilicon layer and the boron-rich layer undesirably coated on the front side of the silicon wafer substrate.

Preferably, after the lightly doped selective emitter is prepared, the back side of the silicon wafer substrate is sequentially subjected to etching, cleaning, and depositing a tunnel layer and a doped polysilicon layer; then a first wet chemical cleaning is performed; and then preparation of the heavily doped selective emitter, a second wet chemical cleaning, deposition of a front aluminum oxide layer, deposition of double-sided passivation film layers, and preparation of double-sided metal electrodes are sequentially performed.

At this time, the first wet chemical cleaning is for removing the polysilicon layer on the front side of the silicon wafer substrate, and the second wet chemical cleaning is for removing the boron-rich layer and a laser-damaged layer on the front side of the silicon wafer substrate.

In the present disclosure, the operations for preparing the heavily doped selective emitter can be adjusted according to actual situations. The preparation of the laser-doped heavily doped selective emitter can be carried out after the preparation of the lightly doped emitter.The preparation of the laser-doped heavily doped selective emitter can also be carried out after the preparation of the tunnel layer and the doped polysilicon layer.

In the present disclosure, the tunnel layer includes any one of a silicon oxide layer, a silicon oxynitride layer, a silicon nitride layer, or an aluminum oxide layer. The tunnel layer is deposited on the back side of the silicon wafer substrate by thermal oxidation or chemical vapor deposition methods.

Preferably, depositing the doped polysilicon layer includes:
depositing an intrinsic amorphous silicon layer onto a surface of the tunnel layer by a chemical vapor deposition method and doping the intrinsic amorphous silicon layer with phosphorus by a diffusion method to obtain a doped amorphous silicon layer, or depositing a doped amorphous silicon layer onto a surface of the tunnel layer by a chemical vapor deposition method; and
performing annealing activation to obtain the doped polysilicon layer.

In the present disclosure, the intrinsic amorphous silicon layer can be deposited on the surface of the tunnel layer by low-pressure chemical vapor deposition or plasma enhanced chemical vapor deposition, then the intrinsic amorphous silicon layer is doped with phosphorus by a diffusion method, and annealing activation is performed to obtain the doped amorphous siliconlayer. Alternatively, the doped amorphous silicon layer can be deposited on the surface of the tunnel layer by low-pressure chemical vapor deposition or plasma enhanced chemical vapor deposition, and annealing activation is performed to obtain the doped amorphous silicon layer.

Preferably, the front aluminum oxide layer is prepared by atomic layer deposition.

Preferably, the double-sided passivation film layers include a front passivation film layer and a back passivation film layer.

Preferably, the front passivation film layer and the back passivation film layer are both prepared by plasma chemical vapor deposition.

Preferably, the front passivation film layer is deposited on a surface of the front aluminum oxide layer.

In the present disclosure, the front passivation film layer includes any one of, or a combination of at least two of, a SiNx passivation film layer, a silicon oxide passivation film layer, or a SiOxNy passivation film layer.

Preferably, the back passivation film layer is deposited on a surface of the doped polysilicon layer.

In the present disclosure, the back passivation film layer includes any one of, or a combination of at least two of, a SiNx passivation film layer, a silicon oxide passivation film layer, or a SiOxNy passivation film layer.

Preferably, the metal electrodes are prepared by printing and sintering sequentially.

Preferably, the metal electrodes include a front metal electrode and a back metal electrode.

Preferably, the front metal electrode passes through the front passivation film layer and the front aluminum oxide layer, and forms ohmic contact with the heavily doped selective emitter.

Preferably, a width of an electrode grid line of the front metal electrode is less than that of the heavily doped selective emitter.

Preferably, the front metal electrode is printed with silver paste or silver-aluminum paste.

Preferably, the back metal electrode is printed with silver paste.

Preferably, the back metal electrode passes through the back passivation film layer, and forms ohmic contact with the back doped polysilicon layer.

In a third aspect, the present disclosure provides a selective emitter cell. The selective emitter cell is obtained by using the method for preparing a selective emitter cell as described in the second aspect.

### Example 1

This example provides a method for preparing a selective emitter cell as shown in Figure 1. The preparation method includes the following steps.
(1) A surface of a N-type silicon wafer was textured and cleaned to obtain a silicon wafer substrate 1.
(2) The silicon wafer substrate 1 was subjected to a diffusion treatment, during which a boron source was added, thereby forming a lightly doped emitter 2 with a surface concentration of 1E19 cm⁻³, a junction depth of 1 µm and a sheet resistance of 300 Ω/sq on the front side of the silicon wafer substrate 1, and forming a boron-rich layer with a thickness of 0.1 µm on the surface of the lightly doped emitter 2.
(3) The lightly doped emitter 2 was patterned-doped with boron atoms in the boron-rich layer using an ultraviolet laser with a wavelength of 325 nm, and then a same region of the lightly doped emitter 2 was patterned-doped with boron atoms in the boron-rich layer using a green laser with a wavelength of 532 nm to obtain a heavily doped selective emitter 3 with a surface concentration of 2E20 cm⁻³, a junction depth of 3 µm, and a sheet resistance of 90 S2/sq.
(4) A back side of the silicon wafer substrate 1 was etched to remove the undesired diffusion on the back side, followed by re-polishing and texturing, and cleaning the surface.
(5) A silicon oxide tunnel layer 7 was grown on the back side of the silicon wafer substrate 1 by thermal oxidation, then an intrinsic amorphous silicon layer with a thickness of 120 nm was deposited on the surface of the silicon oxide tunnel layer 7 by a chemical vapor deposition method at a deposition temperature of 600°C, then the intrinsic amorphous silicon layer was doped with phosphorus by a diffusion method, and then annealing activation was performed at a temperature of 950°C to obtain a doped polysilicon layer 8. After that, wet chemical cleaning was performed to remove the polysilicon layer and the boron-rich layer on the front side of the silicon wafer substrate 1.
(6) A front aluminum oxide layer 4 and a front passivation film layer 5 were sequentially deposited onto the surface of the lightly doped emitter 2 by a plasma chemical vapor deposition method. The front passivation film layer 5 was a SiNx passivation film layer. A total thickness of the front aluminum oxide layer 4 and the SiNx passivation film layer was 80 nm.
(7) A back passivation film layer 9 with a thickness of 75 nm was deposited onto the surface of the doped polysilicon layer 8 by a plasma chemical vapor deposition method. The back passivation film layer 9 was a SiNx passivation film layer.
(8) A front metal electrode 6 was obtained by silver-aluminum paste printing and sintering in sequence, wherein a width of an electrode grid line of the front metal electrode 6 was less than that of the heavily doped selective emitter 3. A back metal electrode 10 was obtained by silver paste printing and sintering in sequence. Thus, a selective emitter cell was obtained.

### Example 2

This example provides a method for preparing a selective emitter cell as shown in Figure 1. The preparation method includes the following steps.
(1) A surface of a N-type silicon wafer was textured and cleaned to obtain a silicon wafer substrate 1.
(2) The silicon wafer substrate 1 was subjected to a diffusion treatment to form a lightly doped emitter 2 with a surface concentration of 1E18 cm⁻³, a junction depth of 2 µm and a sheet resistance of 500 Ω/sq on the front side of the silicon wafer substrate 1. Then, a boron source was applied on the surface of the lightly doped emitter 2 by spin coating, and a boron-rich layer with a thickness of 2 µm was formed after drying.
(3) The lightly doped emitter 2 was patterned-doped with boron atoms in the boron-rich layer using an infrared laser with a wavelength of 1064 nm, and then a same region of the lightly doped emitter 2 was patterned-doped with boron atoms in the boron-rich layer using an ultraviolet laser with a wavelength of 325 nm to obtain a heavily doped selective emitter 3 with a surface concentration of 3E18 cm⁻³, a junction depth of 5 µm, and a sheet resistance of 200 Ω/sq.
(4) A back side of the silicon wafer substrate 1 was etched to remove the undesired diffusion on the back side, followed by re-polishing and texturing, and cleaning the surface.
(5) A silicon oxide tunnel layer 7, and a doped amorphous silicon layer with a thickness of 100 nm were sequentially stacked on the back side of the silicon wafer substrate 1 by a chemical vapor deposition method at a deposition temperature of 450°C, and then annealing activation was performed at a temperature of 900°C to obtain a doped polysilicon layer 8. After that, wet chemical cleaning was performed to remove the polysilicon layer and the boron-rich layer on the front side of the silicon wafer substrate 1.
(6) A aluminum oxide layer and a front passivation film layer 5 were sequentially deposited onto the surface of the lightly doped emitter 2 by a plasma chemical vapor deposition method. The front passivation film layer 5 was a SiNx passivation film layer. A total thickness of the aluminum oxide layer and the SiNx passivation film layer was 85 nm.
(7) A back passivation film layer 9 with a thickness of 65 nm was deposited onto the surface of the doped polysilicon layer 8 by a plasma chemical vapor deposition method. The back passivation film layer 9 was a SiNx passivation film layer.
(8) A front metal electrode 6 was obtained by silver-aluminum paste printing and sintering in sequence, wherein a width of an electrode grid line of the front metal electrode 6 was less than that of the heavily doped selective emitter 3. A back metal electrode 10 was obtained by silver paste printing and sintering in sequence. Thus, a selective emitter cell was obtained.

### Example 3

This example provides a method for preparing a selective emitter cell as shown in Figure 1. The preparation method includes the following steps.
(1) A surface of a N-type silicon wafer was textured and cleaned to obtain a silicon wafer substrate 1.
(2) The silicon wafer substrate 1 was subjected to a diffusion treatment, during which a boron source was added, thereby forming a lightly doped emitter 2 with a surface concentration of 2E20 cm⁻³, a junction depth of 0.1 µm and a sheet resistance of 100 Ω/sq on the front side of the silicon wafer substrate 1, and forming a boron-rich layer with a thickness of 0.01 µm on the surface of the lightly doped emitter 2.
(3) A back side of the silicon wafer substrate 1 was etched to remove the undesired diffusion on the back side, followed by re-polishing and texturing, and cleaning the surface.
(4) A silicon oxide tunnel layer 7 was grown on the back side of the silicon wafer substrate 1 by thermal oxidation, then an intrinsic amorphous silicon layer with a thickness of 120 nm was deposited on the surface of the silicon oxide tunnel layer 7 by a chemical vapor deposition method at a deposition temperature of 600°C, then the intrinsic amorphous silicon layer was doped with phosphorus by a diffusion method, and then annealing activation was performed at a temperature of 900°C to obtain a doped polysilicon layer 8. After that, wet chemical cleaning was performed to remove the polysilicon layer and the boron-rich layer on the front side of the silicon wafer substrate 1.
(5) The lightly doped emitter 2 was patterned-doped with boron atoms in the boron-rich layer using an ultraviolet laser with a wavelength of 325 nm, and then a same region of the lightly doped emitter 2 was patterned-doped with boron atoms in the boron-rich layer using a infrared laser with a wavelength of 1064 nm to obtain a heavily doped selective emitter 3 with a surface concentration of 1E22 cm⁻³, a junction depth of 0.2 µm, and a sheet resistance of 20 S2/sq. Then, wet chemical cleaning was performed to remove the boron-rich layer and a laser-damaged layer on the front side of the silicon wafer substrate 1.
(6) A aluminum oxide layer and a front passivation film layer 5 were sequentially deposited onto the surface of the lightly doped emitter 2 by a plasma chemical vapor deposition method. The front passivation film layer 5 was a SiNx-silicon oxide passivation film layer. A total thickness of the aluminum oxide layer and the SiNx-silicon oxide passivation film layer was 130 nm.
(7) A back passivation film layer 9 with a thickness of 65 nm was deposited onto the surface of the doped polysilicon layer 8 by a plasma chemical vapor deposition method. The back passivation film layer 9 was a SiNx passivation film layer.
(8) A front metal electrode 6 was obtained by silver-aluminum paste printing and sintering in sequence, wherein a width of an electrode grid line of the front metal electrode 6 was less than that of the heavily doped selective emitter 3. A back metal electrode 10 was obtained by silver paste printing and sintering in sequence. Thus,a selective emitter cell was obtained.

In Examples 1 to 3, lasers with two wavelengths were used to sequentially patterned-dope a same region on the surface of the lightly doped emitter 2 with boron atoms in the boron-rich layer. In Examples 1 and 3, a laser with a wavelength less than 450 nm and a laser with a wavelength greater than 450 nm were used to sequentially patterned-dope a same region on the surface of the lightly doped emitter 2 with boron atoms in the boron-rich layer. In Example 2, a laser with a wavelength greater than 450 nm and a laser with a wavelength less than 450 nm were used to sequentially patterned-dope a same region on the surface of the lightly doped emitter 2 with boron atoms in the boron-rich layer. In Examples 1 to 3, the surface concentration and junction depth of the laser region can be precisely controlled to obtain the heavily doped selective emitter 3, thereby increasing the surface concentration of the heavily doped selective emitter 3 and increasing the junction depth. Therefore, the present disclosure takes advantage of the characteristics that the surface of the boron-rich layer responds differently to lasers with different wavelengths, and uses lasers with two or more wavelengths to sequentially patterned-dope a same region on the surface of the lightly doped emitter 2 with boron atoms in the boron-rich layer, which can precisely control the surface concentration and junction depth of the laser region to obtain a heavily doped selective emitter 3, thereby increasing the surface concentration of the heavily doped selective emitter 3 and increasing the junction depth at the same time.

The method for preparing the emitter, and the method for preparing the selective emitter cell, as well as the selective emitter cell, provided in the present disclosure take advantage of the characteristics that the surface of the boron-rich layer responds differently to lasers with different wavelengths and that lasers with different wavelengths cause different depths of thermal effects on silicon, and use lasers with at least two wavelengths to perform boron doping on the surface of a silicon wafer, which can effectively adjust the concentration and depth of boron doping on the surface of the silicon wafer. Besides, in the process of preparing selective emitter cells, lasers with two or more wavelengths are used to sequentially perform patterned laser doping, which can precisely control the surface concentration and junction depth of the laser region to obtain a heavily doped selective emitter, thereby increasing the surface concentration of the heavily doped selective emitter and increasing the junction depth at the same time. In addition, the method for preparing the selective emitter cell provided in the present disclosure is simple and easy to operate, enables to reduce the production time cost, and opens up the process window, promoting the development of high-efficient solar cell preparation technology.

## Claims

1. A method for preparing an emitter, comprising:
irradiating a boron-rich layer sequentially with at least two lasers with different wavelengths to sequentially dope a same region of a silicon wafer with boron atoms in the boron-rich layer, thereby obtaining the emitter.

2. The method according to claim 1, wherein the irradiating the boron-rich layer sequentially with at least two lasers with different wavelengths comprises irradiating the boron-rich layer with a first laser and then irradiating the boron-rich layer with a second laser;
preferably, a wavelength of the first laser is less than 450 nm, and a wavelength of the second laser is greater than 450 nm.

3. The method according to claim 1, wherein the irradiating the boron-rich layer sequentially with at least two lasers with different wavelengths comprises irradiating the boron-rich layer with a first laser and then irradiating the boron-rich layer with a second laser;
preferably, a wavelength of the first laser is greater than 450 nm, and a wavelength of the second laser is less than 450 nm.

4. A method for preparing a selective emitter cell, comprising:
texturing a silicon wafer, preparing a lightly doped emitter and a boron-rich layer, preparing a heavily doped selective emitter, and preparing metal electrodes, thereby obtaining the selective emitter cell;
wherein the heavily doped selective emitter is prepared by the method for preparing an emitter according to any one of claims 1 to 3; a first laser doping and a second laser doping are for sequentially patterned doping a same region on a surface of the lightly doped emitter with boron atoms in the boron-rich layer to obtain the heavily doped selective emitter; and the heavily doped selective emitter is embedded in the lightly doped emitter.

5. The method according to claim 4, wherein a surface of the silicon wafer is textured to obtain a silicon wafer substrate;
preferably, the silicon wafer comprises an N-type silicon wafer;
preferably, the preparing the lightly doped emitter comprises:
subjecting the silicon wafer substrate to a diffusion treatment to form the lightly doped emitter on a front side of the silicon wafer substrate;
preferably, a surface concentration of the lightly doped emitter is in a range from 1E18 cm⁻³ to 2E20 cm⁻³;
preferably, a junction depth of the lightly doped emitter is in a range from 0.1 µm to 2 µm;
preferably, a sheet resistance of the lightly doped emitter is in a range from 100 S2/sq to 500 S2/sq;
preferably, the surface of the lightly doped emitter is covered with the boron-rich layer;
preferably, a thickness of the boron-rich layer is in a range from 0.01 µm to 2 µm;
preferably, a surface concentration of the heavily doped emitter is in a range from 3E18 cm⁻³ to 1E22 cm⁻³;
preferably, a junction depth of the heavily doped emitter is in a range from 0.2 µm to 5 µm;
preferably, a sheet resistance of the heavily doped emitter is in a range from 20 Ω/sq to 200 S2/sq.

6. The method according to claim 4 or 5, further comprising:
after the heavily doped selective emitter is prepared, sequentially subjecting a back side of the silicon wafer substrate to etching, cleaning, and depositing a tunnel layer and a doped polysilicon layer; and then sequentially performing wet chemical cleaning, deposition of a front aluminum oxide layer, deposition of double-sided passivation film layers, and preparation of double-sided metal electrodes.

7. The method according to claim 4 or 5, further comprising:
after the lightly doped selective emitter is prepared, sequentially subjecting a back side of the silicon wafer substrate to etching, cleaning, and depositing a tunnel layer and a doped polysilicon layer; then performing a first wet chemical cleaning; and then sequentially performing preparation of the heavily doped selective emitter, a second wet chemical cleaning, deposition of a front aluminum oxide layer, deposition of double-sided passivation film layers, and preparation of double-sided metal electrodes.

8. The method according to claim 6 or 7, wherein the depositing the doped polysilicon layer comprises:
depositing an intrinsic amorphous silicon layer onto a surface of the tunnel layer by a chemical vapor deposition method and doping the intrinsic amorphous silicon layer with phosphorus by a diffusion method to obtain a doped amorphous silicon layer, or depositing a doped amorphous silicon layer onto a surface of the tunnel layer by a chemical vapor deposition method; and performing annealing activation to obtain the doped polysilicon layer;
preferably, the front aluminum oxide layer is prepared by atomic layer deposition;
preferably, the double-sided passivation film layers comprise a front passivation film layer and a back passivation film layer;
preferably, the front passivation film layer and the back passivation film layer are both prepared by plasma chemical vapor deposition;
preferably, the front passivation film layer is deposited on a surface of the front aluminum oxide layer;
preferably, the back passivation film layer is deposited on a surface of the doped polysilicon layer.

9. The method according to any one of claims 4 to 8, wherein the metal electrodes are prepared by printing and sintering sequentially;
preferably, the metal electrodes comprise a front metal electrode and a back metal electrode;
preferably, the front metal electrode passes through the front passivation film layer and the front aluminum oxide layer, and forms ohmic contact with the heavily doped selective emitter;
preferably, a width of an electrode grid line of the front metal electrode is less than that of the heavily doped selective emitter;
preferably, the front metal electrode is printed with silver paste or silver-aluminum paste; preferably, the back metal electrode is printed with silver paste;
preferably, the back metal electrode passes through the back passivation film layer, and forms ohmic contact with the back doped polysilicon layer.

10. A selective emitter cell, obtained by using the method for preparing a selective emitter cell according to any one of claims 5 to 9.
